# EUROPEAN PATENT APPLICATION

(11) **EP 1 009 210 A2**
(43) Date of publication of application: **14.06.2000**
(21) Application number: 99309844.1
(22) Date of filing: 07.12.1999
(51) Int. Cl.: H05K 7/14

(54) **A housing for an electrical circuit**

(30) Priority: 07.12.1998 GB 9826834
(71) Applicant: Alstom UK Limited, Rugby, Warwickshire CV21 1TB (GB)
(72) Inventor: Lee, Henry John, Alsager, Cheshire ST7 2PZ (GB)
(74) Representative: Spall, Christopher John

(57) **Abstract**

A housing (1) is disclosed for an electrical circuit comprising a frame member (2,3,4) and at least one support member (10), the support member (10) being adapted to support at least part of the electrical circuit with the frame. One of the members includes a sheet metal panel including a number of raised portions (7) having aligned elongated slits (8) forced therein into which a guide rail, such as an edge of the other member, is adapted to be slidably received. In one arrangement, the raised portions may be formed by pressing from a sheet panel using a CNC process.

## Description

This invention relates to improvements in housings for an electrical circuit, and in particular but not exclusively to a housing comprising a frame member and at least one support member adapted to support a number of electrical components within the housing.

It is known to divide an electrical circuit for an electrical apparatus into sub-circuits which each comprise one or more electrical components on a support assembly such as a printed circuits board. Connection between each sub-circuit can be provided by multi-way cables. A casing for the support assemblies may include an elongate guide rail which co-operates with one end of the printed circuit board to allow each support assembly to be slid into and out of the casing. The guide rail may also serve to lock the PCB in place and provide electrical connection to components on the PCB.

A problem with this arrangement arises when the electrical circuit includes a number of heavy electrical components. The weight of these components may cause the board to crack. Where the guide rails also act to provide an electrical connection to the boards, the form of the guide rails is quite complex, and correct alignment of the boards becomes critical.

In accordance with a first aspect, the invention provides a housing for an electrical circuit comprising a frame member and at least one support member, the support member being adapted to support at least part of the electrical circuit within the frame, wherein one of the members includes a sheet metal panel including a number of raised portions having aligned elongate slits formed therein into which a guide rail defined by part of the other member is adapted to be slidably received.

By providing the raised and slit portions on a sheet metal panel, a cheap and simple to produce guide is provided by which the support member can slide relative to the frame member. This allows the support member to be quickly inserted into or removed from the housing unit with its weight evenly distributed.

Preferably, the support member comprises a guide rail and the raised portions having slits are formed on the frame member. In a most preferred arrangement, the frame member comprises a box like structure formed at least partially from sheet metal/with the raised portions provided at the top and bottom. A guide rail provided at the top and bottom of the support member co-operates respectively with the raised portions on the top and bottom of the casing.

The guide rail may be simply provided by an edge of a sheet metal panel forming part of the support member. The edge of the panel may first be folded back on itself to form a smooth edge to assist in sliding relative to the casing.

Preferably, two, three or four or more support members may be slidably received within the frame member. Thus, a number of groups of raised and slit portions may be provided, each group co-operating with a respective support member.

In a refinement, in addition to the raised and slit portions, depressed and slit portions may be provided which extend out of the plane of the sheet metal in the opposite direction to the raised and slit portions. They may be substantially identical in construction to the raised portions.

The raised (or depressed) and slit portions may be easily produced in a flat metal sheet using any standard computer numerical control (CNC) process. In a preferred method, they are formed by first cutting or stamping an elongate slit into the sheet. An area of metal around the slit can then be punched or otherwise deformed to deform the edges of the slit and a portion of the surrounding metal out of the plane of the sheet. Alternatively, the slit may be formed after deforming the metal out of the plane of the sheet, or substantially simultaneously.

In one arrangement, a substantially circular area of metal having a diameter substantially equal to or less than the length of its respective slit is deformed to produce a truncated frusto-conical portion out of the plane of the sheet. Another preferred shape is that of a dome with a slit running across its diameter to split the dome into two halves.

The frame member may include a dividing panel, for example dividing the casing into two halves horizontally with one above the other. In this case, raised and slit portions and depressed and slit portions may be provided on opposing sides of the dividing panel to guide support assemblies, located in each half of the casing, i.e. above and below the divider.

An advantage of such a sheet metal dividing panel is that the depth of the dividing panel is small (simply the thickness of the panel). This enables the dimensions of the case to be minimised.

The metal sheet panel may be steel or aluminium or any other metal which can be permanently deformed to produce the raised portions. It is also envisaged that other non-metal sheet material may be suitable.

In a preferred arrangement, the frame member comprises a substantially box-like structure comprising sheet metal side panels, a sheet metal top panel, bottom panel and rear panel. The raised and slit portions may project into the casing from the top and bottom panels so the support assemblies can be slid into the casing alongside one another. Of course, in an alternative the raised and slit portions may project into the frame member from the side panels to enable the support members to be slid into the frame member above one another.

In accordance with a second aspect, the invention provides a motor controller comprising a motor control circuit contained at least partially within a housing in accordance with the first aspect of the invention.

It will also be understood that the invention, in another aspect, provides a system of slidably engaging a first assembly with a second assembly by co-operation between raised and slit portions of a sheet metal plate forming a part of the first assembly and an elongate rail forming a part of the second assembly, said rail being adapted to slide within said slits in said portions.

There will now be described, by way of example only, one embodiment of the present invention with reference to the accompanying drawings of which:
**Figure 1** is a partial view of a pair of support assemblies mounted within a casing for an electrical circuit;
**Figure 2** is an enlarged view of the circled portion of the assemblies and casing of Figure 1;
**Figure 3** corresponds to Figure 1 with one of the support assemblies partially withdrawn; and
**Figure 4** shows the casing integrated into a larger frame to completely enclose the support assemblies

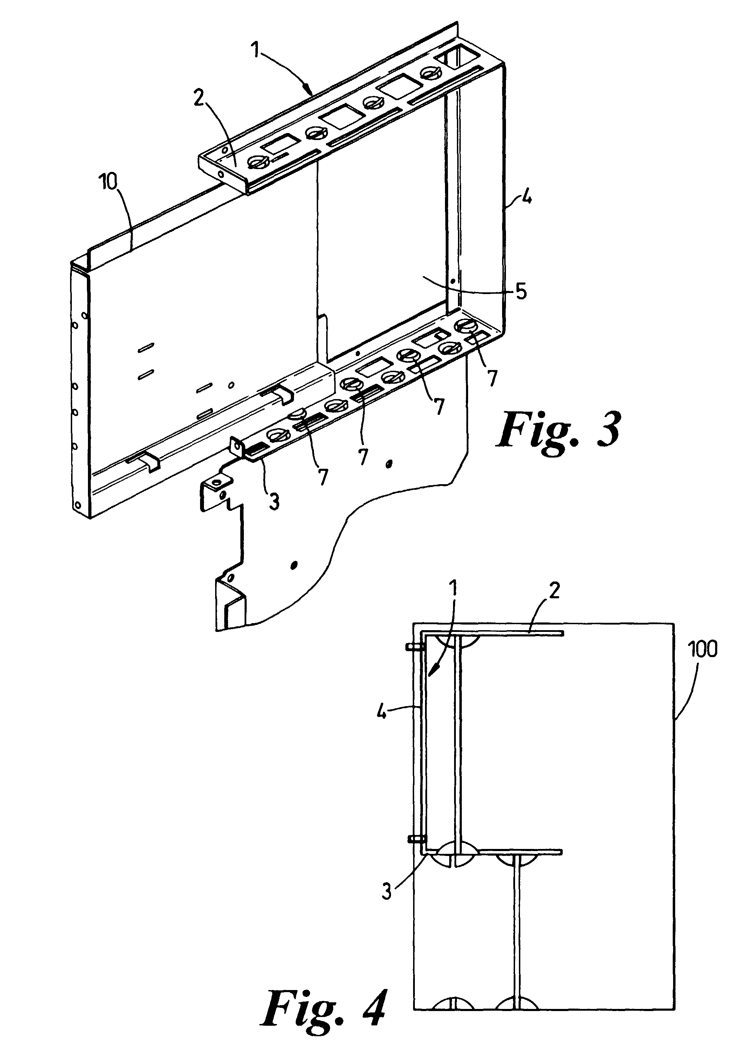

A housing 1 comprising a top panel 2, a bottom panel 3 and a back panel 4 defines a frame member. A single side panel 5 is also visible in Figure 3, attached to the remaining panels by bolts (not shown) in holes 6. As shown, the top, back and bottom panel are fabricated by folding a single sheet of metal.

A number of inwardly directed raised and slotted portions 7 are provided in the top panel 2. A number of identical inwardly directed raised and slotted portions 7 are also formed into the bottom panel 3. The portions 7 all project into the housing and act as a guide for a support member 10.

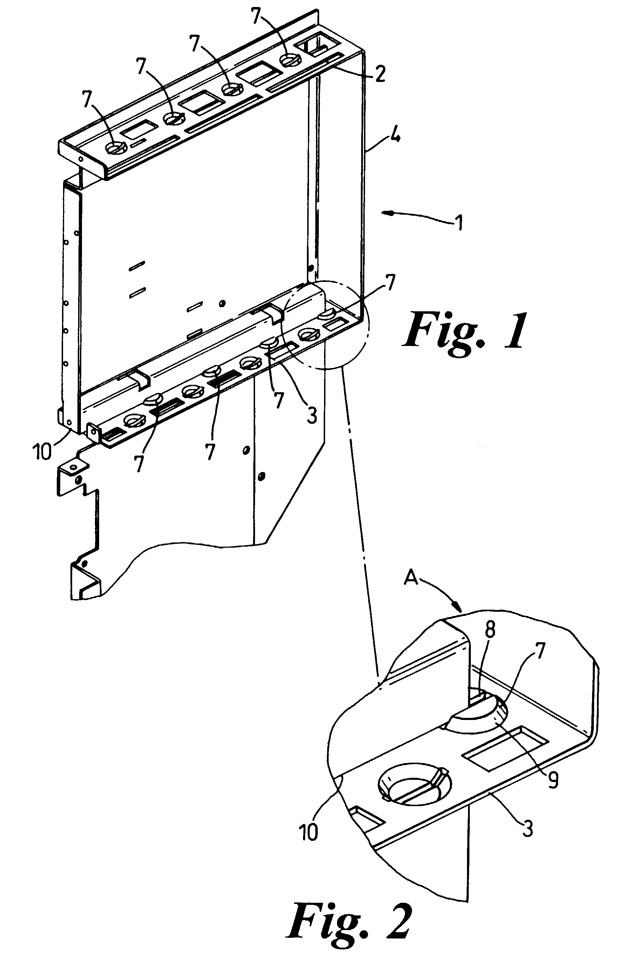

An enlarged view of a portion of Figure 1 is shown in Figure 2 of the accompanying drawings showing the raised and slit portions 7 in more detail. Each one comprises a slot 8 formed into the panel, with a portion of metal 9 surrounding the slot 8 deformed out of the plane of the metal sheet to form a truncated frusto-cone bisected by the slot 8. The top panel 2 has four such portions arranged spaced apart in a row, each one having a slot aligned axially with the slot in the remaining portions. The bottom panel 3 also has four such portions, the slots of these also being aligned and the portions being spaced apart in a row.

The support member 10 comprises a sheet metal pressing onto which a portion of an electrical circuit (not shown) can be mounted. A top edge and bottom edge of the sheet is adapted to co-operate with the portions 7 in the top and bottom panels 2,3 respectively to allow the support assembly 10 to be slid into and out of the housing 1 along the slots.

Also as shown in Figure 1, a second set of portions are formed into the bottom panel. These depend downwards out of the housing and one adaptor to co-operate with a second support assembly on the outside of the bottom panel (i.e. other side to the first support assembly).

As shown in Figure 3, the support assembly that is received within the housing is shown partially withdrawn from the housing.

It will be readily appreciated that the housing does not need to completely encase the support assemblies. Indeed, as shown, in Figure 4 the housing may be adapted to form part of a larger housing assembly 100 with the bottom panel forming an intermediate divider as shown. Of course, the housing 1 could be modified to completely encase the support assemblies if required.

## Claims

1. A housing (1) for an electrical circuit comprising a frame member (2,3,4) and at least one support member (10), the support member (10) being adapted to support at least part of the electrical circuit within the frame, characterised in that one of the members (10,2,3,4) includes a sheet metal panel including a number of raised portions (7) having aligned elongate slits (8) formed therein into which a guide rail defined by part of the other member is adapted to be slidably received.

2. A housing (1) according to claim 1 characterised in that the support member (10) comprises a guide rail and the raised portions (7) having slits (8) are formed on the frame member (2,3,4).

3. A housing according to claim 1 or 2 characterised in that the frame member (2,3,4) comprises a box like structure formed at least partially from sheet metal/with the raised portions (7) provided at the top and bottom, a guide rail provided at the top and bottom of the support member (10) co-operating respectively with the raised portions (7) on the top and bottom of the frame member.

4. A housing (1) according to any preceding claim characterised in that the guide rail is provided by an edge of a sheet metal panel forming part of the support member (10).

5. A housing (1) according to any preceding claim characterised in that two, three or four or more support members (10) are slidably received within the frame member.

6. A housing (1) according to any preceding claim characterised in that depressed and slit portions are provided which extend out of the plane of the sheet metal in the opposite direction to the raised and slit portions (7).

7. A housing (1) according to claim 6 characterised in that the depressed and slit portions are substantially identical in construction to the raised portions (7).

8. A housing according to any preceding claim characterised in that the raised and slit portions (7) are formed by cutting or stamping an elongate slit (8) into the sheet, whereafter an area (9) of metal around the slit is punched or otherwise deformed to deform the edges of the slit (8) and a portion of the surrounding metal out of the plane of the sheet.

9. A housing (1) according to any preceding claim characterised in that a substantially circular area of metal having a diameter substantially equal to or less than the length of its respective slit is deformed to produce a truncated frusto-conical portion out of the plane of the sheet.

10. A housing (1) according to any preceding claim characterised in that the frame member includes a dividing panel and raised and slit portions and depressed and slit portions are provided on opposing sides of the dividing panel.

11. A housing according to any preceding claim characterised in that the metal sheet panel is steel or aluminium.

12. A housing according to any preceding claim characterised in that the frame member comprises a substantially box-like structure comprising sheet metal side panels (5), a sheet metal top panel (2), bottom panel (3) and rear panel (4).

13. A motor controller comprising a motor control circuit contained at least partially within a housing in accordance with any one of claims 1 to 12.
